# EUROPEAN PATENT APPLICATION

(11) **EP 2 814 077 A1**
(43) Date of publication of application: **17.12.2014**
(21) Application number: 13746641.3
(22) Date of filing: 07.02.2013
(51) Int. Cl.: H01L 51/46, H01L 31/072

(54) **ORGANIC THIN FILM SOLAR CELL**

(30) Priority: 07.02.2012 JP 2012024451; 21.03.2012 JP 2012063910
(71) Applicant: Sekisui Chemical Co., Ltd., Osaka-shi, Osaka 530-0047 (JP)
(72) Inventor: HAYAKAWA Akinobu, Mishima-gun Osaka 618-0021 (JP); ITO Kazushi, Mishima-gun Osaka 618-0021 (JP); SUN Ren-de, Mishima-gun Osaka 618-0021 (JP)
(74) Representative: Hart-Davis, Jason
(86) International application number: PCT/JP2013/052793
(87) International publication number: WO 2013/118793

(57) **Abstract**

The present invention aims to provide an organic thin-film solar cell that has a high photoelectric conversion efficiency and excellent durability. The present invention is an organic thin-film solar cell including a photoelectric conversion layer, wherein the photoelectric conversion layer includes a portion containing a sulfide of a Group 15 element in the periodic table and an organic semiconductor portion contacting with each other, and the organic semiconductor portion comprises an organic semiconductor, the organic semiconductor comprising a polythiophene derivative, a phthalocyanine derivative, a naphthalocyanine derivative, or a benzoporphyrin derivative.

## Description

### TECHNICAL FIELD

The present invention relates to an organic thin-film solar cell that has a high photoelectric conversion efficiency and excellent durability.

### BACKGROUND ART

Photoelectric conversion elements have been developed which include a laminated body of a plurality of kinds of semiconductors and electrodes disposed on both sides of the laminated body. Instead of such a laminated body, use of a composite film produced by mixing a plurality of kinds of semiconductors has also been examined. In such photoelectric conversion elements, each semiconductor acts as a P-type semiconductor or an N-type semiconductor. Photocarriers (electron-hole pairs) are generated by photoexcitation in the P-type semiconductor or N-type semiconductor so that electrons and holes move through the N-type semiconductor and P-type semiconductor, respectively, to create electric fields.

Most photoelectric conversion elements practically used nowadays are inorganic solar cells produced by use of inorganic semiconductors formed of silicon or other materials. Unfortunately, production of inorganic solar cells is costly, and upsizing is difficult, which limits the range of applications. Thus, organic solar cells produced by use of organic semiconductors, instead of inorganic semiconductors, are attracting interest.

Most organic solar cells include fullerenes. Fullerenes are known to act mainly as an N-type semiconductor. For example, Patent Literature 1 describes a semiconductor hetero-junction film that includes an organic compound which is to act as a P-type semiconductor and fullerenes. However, organic solar cells produced by use of a fullerene are known to deteriorate due to the fullerene (see, for example, Non Patent Literature 1) . It is thus necessary to select materials having higher durability than fullerenes.

Few organic semiconductors are excellent enough to replace fullerenes. Thus, studies have been made on organic solar cells in which an inorganic semiconductor is used instead of a fullerene together with an organic semiconductor. Zinc oxide, titanium oxide, or similar materials are used as an inorganic semiconductor, for example. Such an organic solar cell is described in, for example, Patent Literature 2. The organic solar cell includes an active layer containing an organic electron donor and a compound semiconductor crystal between two electrodes. Unfortunately, the organic solar cell fails to achieve sufficient durability even if zinc oxide, titanium oxide, or similar materials are used. Moreover, it has a lower photoelectric conversion efficiency as compared to those including fullerenes.

### CITATION LIST

### - Patent Literature

Patent Literature 1: JP-A 2006-344794
Patent Literature 2: JP-B 4120362

### - Non Patent Literature

Non Patent Literature 1: Reese et al., Adv.Funct.Mater., 20, 3476-3483(2010)

### SUMMARY OF INVENTION

### - Technical Problem

The present invention aims to provide an organic thin-film solar cell that has a high photoelectric conversion efficiency and excellent durability.

### - Solution to Problem

The present invention relates to an organic thin-film solar cell comprising a photoelectric conversion layer,
wherein the photoelectric conversion layer includes a portion containing a sulfide of a Group 15 element in the periodic table and an organic semiconductor portion contacting with each other, and the organic semiconductor portion comprises an organic semiconductor, the organic semiconductor comprising a polythiophene derivative, a phthalocyanine derivative, a naphthalocyanine derivative, or a benzoporphyrin derivative.

The present invention is described in detail below.

The inventors of the present invention have found out that, if an organic thin-film solar cell comprises a photoelectric conversion layer that includes a portion containing a sulfide of a Group 15 element in the periodic table and an organic semiconductor portion including an organic semiconductor, the organic semiconductor comprising a polythiophene derivative, a phthalocyanine derivative, a naphthalocyanine derivative, or a benzoporphyrin derivative, the organic thin-film solar cell has an enhanced durability while a high photoelectric conversion efficiency is maintained. Accordingly, they completed the present invention.

The organic thin-film solar cell of the present invention comprises a photoelectric conversion layer in which a portion containing a sulfide of a Group 15 element in the periodic table and an organic semiconductor portion contact with each other.

In the photoelectric conversion layer having the aforementioned structure, the portion containing a sulfide of a Group 15 element in the periodic table and the organic semiconductor portion presumably act mainly as an N-type semiconductor and a P-type semiconductor, respectively. Photocarrier (electron-hole pair) is generated by photoexcitation in the P-type semiconductor or N-type semiconductor. Electrons move through the N-type semiconductor, and holes move through the P-type semiconductor to thereby generate electric fields. Meanwhile, the portion containing a sulfide of a Group 15 element in the periodic table may partially act as a P-type semiconductor, and the organic semiconductor portion may partially act as an N-type semiconductor.

Due to high durability of sulfides of Group 15 elements in the periodic table, use of a sulfide of a Group 15 element in the periodic table enables the organic thin-film solar cell of the present invention to have excellent durability.

Moreover, use of an organic semiconductor enables the organic thin-film solar cell of the present invention to have excellent impact resistance, flexibility, or other properties as well.

In the case where both of the N-type semiconductor and the P-type semiconductor are inorganic semiconductors, solid solutions thereof may form deposits on the interface. In contrast, no deposit of solid solutions occurs in the organic thin-film solar cell of the present invention. Thus, high stability can be achieved even at a high temperature.

The photoelectric conversion layer may have any structure as long as the portion containing a sulfide of a Group 15 element in the periodic table and the organic semiconductor portion contact with each other. The photoelectric conversion layer may be a laminated body that includes a layer containing a sulfide of a Group 15 element in the periodic table and an organic semiconductor layer, or may be a composite film formed as a complex containing a mixture of a portion containing a sulfide of a Group 15 element in the periodic table and an organic semiconductor portion. The photoelectric conversion layer is preferably a composite film as it can enhance the charge separation efficiency of the organic semiconductor portion.

The sulfide of a Group 15 element in the periodic table is preferably antimony sulfide or bismuth sulfide, and more preferably antimony sulfide. Antimony sulfide is very compatible with the organic semiconductor in terms of the energy level. Moreover, it has a higher visible light absorption than conventionally used materials such as zinc oxide or titanium oxide. Thus, if antimony sulfide is used as the sulfide of a Group 15 element in the periodic table, the organic thin-film solar cell has a higher photoelectric conversion efficiency. The sulfide of a Group 15 element in the periodic table may be used alone, or two or more kinds thereof may be used in combination.

The sulfide of a Group 15 element in the periodic table may be a complex sulfide in which two or more kinds of Group 15 elements in the periodic table are present in the same molecule.

The portion containing a sulfide of a Group 15 element in the periodic table may contain other elements that do not hinder the effects of the present invention in addition to the sulfide of a Group 15 element in the periodic table. Such other elements are not particularly limited, but are preferably any of the elements of fourth, fifth and sixth periods in the periodic table. Specific examples thereof include indium, gallium, tin, cadmium, copper, zinc, aluminum, nickel, silver, titanium, vanadium, niobium, molybdenum, tantalum, iron, and cobalt. Any of these other elements may be used alone, or two or more kinds thereof may be used in combination. Indium, gallium, tin, cadmium, zinc, or copper is especially preferable as the use thereof enhances electron mobility.

The amount of other elements is preferably 50% by weight at the maximum in the portion containing a sulfide of a Group 15 element in the periodic table. If the amount is not more than 50% by weight, the portion containing a sulfide of a Group 15 element in the periodic table can maintain a certain level or higher of compatibility with the organic semiconductor, which increases the photoelectric conversion efficiency.

The portion containing a sulfide of a Group 15 element in the periodic table is preferably a crystalline semiconductor. If the portion containing a sulfide of a Group 15 element in the periodic table is a crystalline semiconductor, electron mobility is enhanced so that the photoelectric conversion efficiency increases.

The crystalline semiconductor refers to a semiconductor whose scattering peaks can be detected by X-ray diffraction measurement or other techniques.

Degree of crystallinity may be employed as an index of the crystallinity of the portion containing a sulfide of a Group 15 element in the periodic table. The degree of crystallinity of the portion containing a sulfide of a Group 15 element in the periodic table is preferably 30% at the minimum. If the degree of crystallinity is not less than 30%, the electron mobility is enhanced so that the photoelectric conversion efficiency increases. The minimum degree of crystallinity is more preferably 50%, and still more preferably 70%.

The degree of crystallinity can be determined as follows: scattering peaks of a crystalline fraction detected by X-ray diffraction measurement or other techniques and halo due to an amorphous fraction are separated by fitting; integrated intensities thereof are determined; and the proportion of the crystalline fraction in the whole is calculated.

In order to increase the degree of crystallinity of the portion containing a sulfide of a Group 15 element in the periodic table, the portion containing a sulfide of a Group 15 element in the periodic table may be subjected to, for example, thermal annealing, exposure to strong light such as laser or flash lamp, exposure to excimer light, or exposure to plasma. Exposure to strong light or exposure to plasma, for example, is especially preferable as such a technique enables to suppress oxidation of the sulfide of a Group 15 element in the periodic table.

The organic semiconductor forming the organic semiconductor portion is a polythiophene derivative, a phthalocyanine derivative, a naphthalocyanine derivative, or a benzoporphyrin derivative. Use of the aforementioned organic semiconductor together with the sulfide of a Group 15 element in the periodic table produces synergistic effects to enable the organic thin-film solar cell of the present invention to have extremely high charge separation efficiency. Thus, the organic thin-film solar cell of the present invention achieves not only excellent durability but also a high photoelectric conversion efficiency.

Any polythiophene derivative may be used as long as it has a thiophene skeleton in the molecule. Examples of the polythiophene derivative include polyalkylthiophenes, polycarboxythiophene, polybenzothiophene, polybisbenzothiophene, polythienothiophene, thiophene-thienothiophene copolymers, diketopyrrolopyrrole-thiophene copolymers, diketopyrrolopyrrole-bisbenzothiophene copolymers, benzothiadiazole-thiophene copolymers, and dithienopyrrole-thiophene copolymers. Any of these polythiophene derivatives may be used alone, or two or more kinds thereof may be used in combination.

Any phthalocyanine derivative may be used as long as it has a phthalocyanine skeleton in the molecule. Examples of the phthalocyanine derivative include metal-free phthalocyanine, copper phthalocyanine, zinc phthalocyanine, magnesium phthalocyanine, manganese phthalocyanine, α-alkyl group-substituted phthalocyanines, β-alkyl group-substituted phthalocyanines, α-phenyl group-substituted phthalocyanines, β-phenyl group-substituted phthalocyanines, α-alkoxy group-substituted phthalocyanines, β-alkoxy group-substituted phthalocyanines, and halogen-substituted phthalocyanines. Examples thereof further include precursors of phthalocyanine derivatives, i.e., compounds whose chemical structures are changed by heating, exposure to light, or other stimulation to thereby be converted to phthalocyanine derivatives. Any of these phthalocyanine derivatives may be used alone, or two or more kinds thereof may be used in combination.

Any naphthalocyanine derivative may be used as long as it has a naphthalocyanine skeleton in the molecule. Examples of the naphthalocyanine derivative include metal-free naphthalocyanine, copper naphthalocyanine, zinc naphthalocyanine, magnesium naphthalocyanine, manganese naphthalocyanine, α-alkyl group-substituted naphthalocyanines, β-alkyl group-substituted naphthalocyanines, α-phenyl group-substituted naphthalocyanines, β-phenyl group-substituted naphthalocyanines, α-alkoxy group-substituted naphthalocyanines, β-alkoxy group-substituted naphthalocyanines, and halogen-substituted naphthalocyanines. Examples thereof further include precursors of naphthalocyanine derivatives, i.e., compounds whose chemical structures are changed by heating, exposure to light, or other stimulation to thereby be converted to naphthalocyanine derivatives. Any of these naphthalocyanine derivatives may be used alone, or two or more kinds thereof may be used in combination.

Any benzoporphyrin derivative may be used as long as it has a benzoporphyrin skeleton in the molecule. Examples of the benzoporphyrin derivative include metal-free benzoporphyrin, copper benzoporphyrin, zinc benzoporphyrin, magnesium benzoporphyrin, α-alkyl group-substituted benzoporphyrins, β-alkyl group-substituted benzoporphyrins, α-phenyl group-substituted benzoporphyrins, β-phenyl group-substituted benzoporphyrins, α-alkoxy group-substituted benzoporphyrins, β-alkoxy group-substituted benzoporphyrins, and halogen-substituted benzoporphyrins. Examples thereof further include precursors of benzoporphyrin derivatives, i.e., compounds whose chemical structures are changed by heating, exposure to light, or other stimulation to thereby be converted to benzoporphyrin derivatives. Examples of such precursors include bicycloporphyrin. Any of these benzoporphyrin derivatives may be used alone, or two or more kinds thereof may be used in combination.

The organic semiconductor is preferably of donor-acceptor type as such an organic semiconductor can absorb light in a long wavelength range. Donor-acceptor polythiophene derivatives or donor-acceptor naphthalocyanine derivatives are more preferable. Thiophene-diketopyrrolopyrrole copolymers are particularly preferable among donor-acceptor polythiophene derivatives in view of the light absorption wavelength.

The organic thin-film solar cell of the present invention preferably includes the aforementioned photoelectric conversion layer between a pair of electrodes. The materials of the electrodes are not particularly limited, and may be conventional materials. Examples of the materials of the anode include metals such as gold, conductive transparent materials such as CuI, ITO (indium tin oxide), SnO₂, AZO (aluminum zinc oxide), IZO (indium zinc oxide), or GZO (gallium zinc oxide), and conductive transparent polymers. Examples of the materials of the cathode include sodium, sodium-potassium alloys, lithium, magnesium, aluminum, magnesium-silver mixtures, magnesium-indium mixtures, aluminum-lithium alloys, Al/Al₂O₃ mixtures, and Al/LiF mixtures. Any of these materials may be used alone, or two or more kinds thereof may be used in combination.

The organic thin-film solar cell of the present invention may further include a substrate, a hole transport layer, an electron transport layer, or other members. The substrate is not particularly limited, and examples thereof include transparent glass substrates such as soda-lime glass or alkali-free glass, ceramic substrates, and transparent plastic substrates.

The materials of the hole transport layer are not particularly limited. Examples of the materials include P-type conductive polymers, P-type low molecular weight organic semiconductors, P-type metal oxides, P-type metal sulfides, and surfactants. Specific examples thereof include polystyrene sulfonate-doped polyethylene dioxythiophene, carboxyl group-containing polythiophene, phthalocyanine, porphyrin, molybdenum oxide, vanadium oxide, tungsten oxide, nickel oxide, copper oxide, tin oxide, molybdenum sulfide, tungsten sulfide, copper sulfide, tin sulfide or the like, fluoro group-containing phosphonic acid, and carbonyl group-containing phosphonic acid.

The materials of the electron transport layer are not particularly limited. Examples of the materials include N-type conductive polymers, N-type low molecular weight organic semiconductors, N-type metal oxides, N-type metal sulfides, alkali metal halides, alkali metals, and surfactants. Specific examples thereof include cyano group-containing polyphenylene vinylene, boron-containing polymers, bathocuproine, bathophenanthroline, hydroxy quinolinato aluminum, oxadiazol compounds, benzoimidazole compounds, naphthalene tetracarboxylic acid compounds, perylene derivatives, phosphine oxide compounds, phosphine sulfide compounds, fluoro group-containing phthalocyanine, titanium oxide, zinc oxide, indium oxide, tin oxide, gallium oxide, tin sulfide, indium sulfide, and zinc sulfide.

In particular, the organic thin-film solar cell of the present invention preferably comprises a photoelectric conversion layer that includes a layer containing a sulfide of a Group 15 element in the periodic table and an organic semiconductor layer between a pair of electrodes, and further comprises an electron transport layer between one of the electrodes and the layer containing a sulfide of a Group 15 element in the periodic table. The organic thin-film solar cell of the present invention more preferably comprises an electron transport layer between one of the electrodes and the layer containing a sulfide of a Group 15 element in the periodic table and a hole transport layer between the other electrode and the organic semiconductor layer.

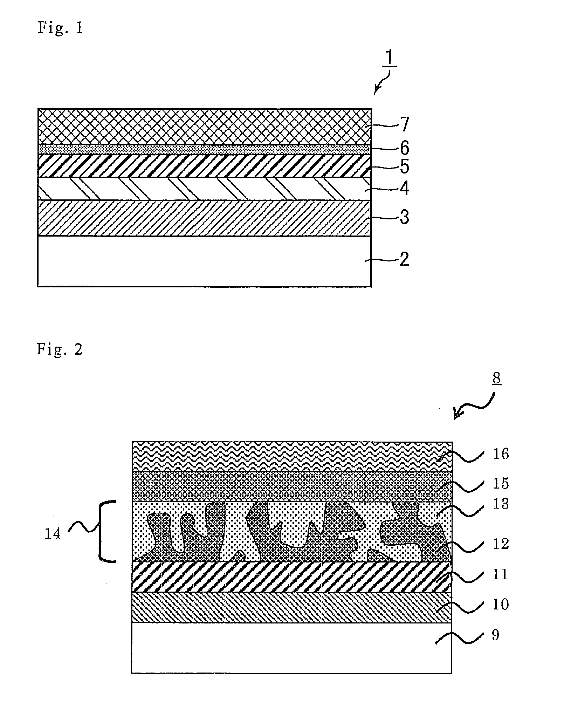

Fig. 1 shows a schematic view of one example of the organic thin-film solar cell of the present invention in which the photoelectric conversion layer is a laminated body. In an organic thin-film solar cell 1 shown in Fig. 1, a substrate 2, a transparent electrode (anode) 3, an organic semiconductor layer 4, a layer 5 containing a sulfide of a Group 15 element in the periodic table, an electron transport layer 6, and an electrode (cathode) 7 are laminated in this order.

Preferably, the organic thin-film solar cell of the present invention includes a photoelectric conversion layer that is a composite film produced by mixing to form a complex of a portion containing a sulfide of a Group 15 element in the periodic table and an organic semiconductor portion between a pair of electrodes, and further includes an electron transport layer between one of the electrodes and the photoelectric conversion layer. Moreover, the organic thin-film solar cell of the present invention preferably includes an electron transport layer between one of the electrodes and the photoelectric conversion layer, and a hole transport layer between the other electrode and the photoelectric conversion layer.

Fig. 2 shows a schematic view of one example of the organic thin-film solar cell of the present invention in which the photoelectric conversion layer is a composite film. In an organic thin-film solar cell 8 shown in Fig. 2, a substrate 9, a transparent electrode (anode) 10, a hole transport layer 11, a composite film 14 including an organic semiconductor portion 12 and a portion containing a sulfide of a Group 15 element in the periodic table 13, an electron transport layer 15, and an electrode (cathode) 16 are laminated in this order.

In the case where the photoelectric conversion layer is a laminated body, the layer containing a sulfide of a Group 15 element in the periodic table preferably has a minimum thickness of 5 nm and a maximum thickness of 5000 nm. The layer containing a sulfide of a Group 15 element in the periodic table having a thickness of not smaller than 5 nm can more sufficiently absorb light to thereby increase the photoelectric conversion efficiency. The layer containing a sulfide of a Group 15 element in the periodic table having a thickness of not larger than 5000 nm can prevent generation of regions where charge separation does not occur to thereby avoid reduction in the photoelectric conversion efficiency. The layer containing a sulfide of a Group 15 element in the periodic table more preferably has a minimum thickness of 10 nm and a maximum thickness of 1000 nm, and still more preferably has a minimum thickness of 20 nm and a maximum thickness of 500 nm.

In the case where the photoelectric conversion layer is a laminated body, the organic semiconductor layer preferably has a minimum thickness of 5 nm and a maximum thickness of 1000 nm. The organic semiconductor layer having a thickness of not smaller than 5 nm can more sufficiently absorb light to thereby increase the photoelectric conversion efficiency. The organic semiconductor layer having a thickness of not larger than 1000 nm can prevent generation of regions where charge separation does not occur to thereby avoid reduction in the photoelectric conversion efficiency. The organic semiconductor layer more preferably has a minimum thickness of 10 nm and a maximum thickness of 500 nm, and still more preferably has a minimum thickness of 20 nm and a maximum thickness of 200 nm.

The hole transport layer preferably has a minimum thickness of 1 nm and a maximum thickness of 200 nm. The hole transport layer having a thickness of not smaller than 1 nm can more sufficiently block electrons. The hole transport layer having a thickness of not larger than 200 nm tends not to create resistance to hole transport to thereby increase the photoelectric conversion efficiency. The hole transport layer more preferably has a minimum thickness of 3 nm and a maximum thickness of 150 nm, and still more preferably has a minimum thickness of 5 nm and a maximum thickness of 100 nm.

The electron transport layer preferably has a minimum thickness of 1 nm and a maximum thickness of 200 nm. The electron transport layer having a thickness of not smaller than 1 nm can more sufficiently block holes. The electron transport layer having a thickness of not larger than 200 nm tends not to create resistance to electron transport to thereby increase the photoelectric conversion efficiency. The electron transport layer more preferably has a minimum thickness of 3 nm and a maximum thickness of 150 nm, and still more preferably has a minimum thickness of 5 nm and a maximum thickness of 100 nm.

In the case where the photoelectric conversion layer is a composite film as mentioned above, the photoelectric conversion layer preferably has a minimum thickness of 30 nm and a maximum thickness of 3000 nm. The photoelectric conversion layer having a thickness of not smaller than 30 nm can more sufficiently absorb light to thereby increase the photoelectric conversion efficiency. The photoelectric conversion layer having a thickness of not larger than 3000 nm enables electric charge to be easily transferred to the electrodes to thereby increase the photoelectric conversion efficiency. The photoelectric conversion layer more preferably has a minimum thickness of 40 nm and a maximum thickness of 1000 nm, and still more preferably has a minimum thickness of 50 nm and a maximum thickness of 500 nm.

In the case where the photoelectric conversion layer is a composite film, the ratio between the portion containing a sulfide of a Group 15 element in the periodic table and the organic semiconductor portion is very important. The ratio between the portion containing a sulfide of a Group 15 element in the periodic table and the organic semiconductor portion is preferably 1:9 to 9:1 (volume ratio). If the ratio is within the above range, holes or electrons easily reach the electrodes, which increases the photoelectric conversion efficiency. The ratio is more preferably 2:8 to 8:2 (volume ratio).

The organic thin-film solar cell of the present invention is produced by any method. For example, in the case where the photoelectric conversion layer is a laminated body, the organic thin-film solar cell of the present invention is produced by the following method: an electrode (anode) is formed on a substrate; an organic semiconductor layer is formed on a surface of the electrode (anode) by a printing method such as spin coating; then a layer containing a sulfide of a Group 15 element in the periodic table is formed on a surface of the organic semiconductor layer by a vacuum evaporation method or other methods; and further an electrode (cathode) is formed on a surface of the layer containing a sulfide of a Group 15 element in the periodic table. Alternatively, after an electrode (cathode) is formed on a substrate, a layer containing a sulfide of a Group 15 element in the periodic table, an organic semiconductor layer, and an electrode (anode) may be formed in this order.

In the production of the organic thin-film solar cell of the present invention, since the organic semiconductor layer can be stably and simply formed by a printing method such as spin coating, the cost for forming the organic semiconductor layer can be reduced. The layer containing a sulfide of a Group 15 element in the periodic table may also be formed not by a vacuum evaporation method but by a printing method such as spin coating using a solution of a precursor of a sulfide of a Group 15 element in the periodic table or a dispersion of nano particles of a sulfide of a Group 15 element in the periodic table.

Moreover, in the case where the photoelectric conversion layer is a composite film, for example, the composite film may be formed of a mixed solution of an organic semiconductor and a solution of a precursor of a sulfide of a Group 15 element in the periodic table or a dispersion of nano particles of a sulfide of a Group 15 element in the periodic table. Furthermore, the composite film may also be formed by co-deposition of a sulfide of a Group 15 element in the periodic table and an organic semiconductor.

### - Advantageous Effects of Invention

The present invention can provide an organic thin-film solar cell that has a high photoelectric conversion efficiency and excellent durability.

### BRIEF DESCRIPTION OF DRAWINGS

Fig. 1 is a cross-sectional view schematically showing one example of the organic thin-film solar cell of the present invention in which the photoelectric conversion layer is a laminated body.
Fig. 2 is a cross-sectional view schematically showing one example of the organic thin-film solar cell of the present invention in which the photoelectric conversion layer is a composite film.

### DESCRIPTION OF EMBODIMENTS

The present invention is described in more detail below referring to, but not limited to, examples.

Examples 1 to 12 and Comparative Examples 1 to 10 each describe production of an organic thin-film solar cell in which a photoelectric conversion layer is a laminated body.

### (Example 1)

### <Anode>

An ITO film having a thickness of 240 nm was formed as an anode on a glass substrate. The ITO film was subjected to ultrasonic cleaning for 10 minutes each with acetone, methanol, and isopropyl alcohol in this order, followed by drying.

### <Photoelectric conversion layer (laminated body)>

A layer of poly(3,4-ethylene dioxythiophene):poly(styrene sulfonate) (PEDOT:PSS) having a thickness of 50 nm was formed as an organic semiconductor layer (acting mainly as a P-type semiconductor) on a surface of the ITO film by spin coating. Thereafter, a layer of antimony sulfide having a thickness of 40 nm was formed as a layer containing a sulfide of a Group 15 element in the periodic table (acting mainly as an N-type semiconductor) on a surface of the organic semiconductor layer by vacuum evaporation.

### <Electron transport layer>

An electron transport layer having a thickness of 50nm was formed using a zinc oxide nanoparticle dispersion on a surface of the layer containing a sulfide of a Group 15 element in the periodic table by spin coating. The layer was annealed at a temperature of 260°C for 2 minutes.

### <Cathode>

An aluminum film having a thickness of 100 nm was formed as a cathode on a surface of the electron transport layer by vacuum evaporation to thereby give an organic thin-film solar cell.

### (Example 2)

### <Cathode>

An ITO film having a thickness of 240 nm was formed as a cathode on a glass substrate. The ITO film was subjected to ultrasonic cleaning for 10 minutes each with acetone, methanol, and isopropyl alcohol in this order, followed by drying.

### <Electron transport layer>

An electron transport layer having a thickness of 50nm was formed using a zinc oxide nanoparticle dispersion on a surface of the ITO film by spin coating.

### <Photoelectric conversion layer (laminated body)>

A layer of antimony sulfide having a thickness of 40 nm was formed as a layer containing a sulfide of a Group 15 element in the periodic table on a surface of the electron transport layer by vacuum evaporation, and then annealed at a temperature of 260°C for 2 minutes. Thereafter, a layer of poly(3-hexylthiophene) having a thickness of 40 nm was formed as an organic semiconductor layer on a surface of the layer containing a sulfide of a Group 15 element in the periodic table by spin coating.

### <Hole transport layer>

A layer of poly(3,4-ethylene dioxythiophene):poly(styrene sulfonate) (PEDOT:PSS) having a thickness of 50 nm was formed as a hole transport layer on a surface of the organic semiconductor layer by spin coating.

### <Anode>

A gold film having a thickness of 100 nm was formed as an anode on a surface of the hole transport layer by vacuum evaporation to thereby give an organic thin-film solar cell.

### (Example 3)

### <Cathode>

An ITO film having a thickness of 240 nm was formed as a cathode on a glass substrate. The ITO film was subjected to ultrasonic cleaning for 10 minutes each with acetone, methanol, and isopropyl alcohol in this order, followed by drying.

### <Photoelectric conversion layer (laminated body)>

A layer of antimony sulfide having a thickness of 40 nm was formed as a layer containing a sulfide of a Group 15 element in the periodic table on a surface of the ITO film by vacuum evaporation, and then annealed at a temperature of 260°C for 2 minutes. Thereafter, a layer of poly(3-hexylthiophene) having a thickness of 40 nm was formed as an organic semiconductor layer on a surface of the layer containing a sulfide of a Group 15 element in the periodic table by spin coating.

### <Hole transport layer>

A layer of poly(3,4-ethylene dioxythiophene):poly(styrene sulfonate) (PEDOT:PSS) having a thickness of 50 nm was formed as a hole transport layer on a surface of the organic semiconductor layer by spin coating.

### <Anode>

A gold film having a thickness of 100 nm was formed as an anode on a surface of the hole transport layer by vacuum evaporation to thereby give an organic thin-film solar cell.

### (Example 4)

An organic thin-film solar cell was produced in the same manner as in Example 2, except that the antimony sulfide was changed to bismuth sulfide.

### (Example 5)

An organic thin-film solar cell was produced in the same manner as in Example 2, except that the annealing temperature for forming the layer containing a sulfide of a Group 15 element in the periodic table was changed to 240°C.

### (Example 6)

An organic thin-film solar cell was produced in the same manner as in Example 2, except that the annealing temperature for forming the layer containing a sulfide of a Group 15 element in the periodic table was changed to 200°C.

### (Example 7)

An organic thin-film solar cell was produced in the same manner as in Example 2, except that the poly (3-hexylthiophene) was changed to a donor-acceptor conductive polymer (PBDTTT-CF, produced by 1-Material).

### (Example 8)

An organic thin-film solar cell was produced in the same manner as in Example 2, except that a layer of copper phthalocyanine having a thickness of 30 nm was formed by an evaporation method instead of the layer of poly(3-hexylthiophene).

### (Example 9)

An organic thin-film solar cell was produced in the same manner as in Example 2, except that a layer of zinc phthalocyanine having a thickness of 30 nm was formed by an evaporation method instead of the layer of poly(3-hexylthiophene).

### (Example 10)

An organic thin-film solar cell was produced in the same manner as in Example 2, except that the poly (3-hexylthiophene) was changed to an α-alkyl group-substituted phthalocyanine (zinc 1,4,8,11,15,18,22,25-octabutoxy-29H,31H-phthalocyanine).

### (Example 11)

An organic thin-film solar cell was produced in the same manner as in Example 2, except that a layer of benzoporphyrin having a thickness of 30 nm was formed by an evaporation method instead of the layer of poly(3-hexylthiophene).

### (Example 12)

An organic thin-film solar cell was produced in the same manner as in Example 2, except that the poly (3-hexylthiophene) was changed to bicycloporphyrin, and the bicycloporphyrin was converted to benzoporphyrin by thermal treatment at 180°C to form a benzoporphyrin layer.

### (Comparative Example 1)

An organic thin-film solar cell was produced in the same manner as in Example 2, except that the antimony sulfide was changed to a fullerene.

### (Comparative Example 2)

An organic thin-film solar cell was produced in the same manner as in Comparative Example 1, except that the annealing temperature for forming the fullerene layer was changed to 180°C.

### (Comparative Example 3)

An organic'thin-film solar cell was produced in the same manner as in Comparative Example 1, except that the fullerene layer was formed without annealing.

### (Comparative Example 4)

An organic thin-film solar cell was produced in the same manner as in Example 2, except that a layer of zinc oxide nano particles was formed by spin coating instead of the antimony sulfide layer.

### (Comparative Example 5)

An organic thin-film solar cell was produced in the same manner as in Example 2, except that the antimony sulfide was changed to tin sulfide.

### (Comparative Example 6)

An organic thin-film solar cell was produced in the same manner as in Example 2, except that a layer of zinc sulfide nano particles was formed by spin coating instead of the antimony sulfide layer.

### (Comparative Example 7)

An organic thin-film solar cell was produced in the same manner as in Example 1, except that a layer of copper sulfide was formed by vacuum evaporation instead of the PEDOT: PSS layer.

### (Comparative Example 8)

An organic thin-film solar cell was produced in the same manner as in Example 2, except that the poly (3-hexylthiophene) was changed to poly[2-methoxy-5-(3',7'-dimethyloctyloxy)-1,4-phenyleneviny lene] (MDMO-PPV).

### (Comparative Example 9)

An organic thin-film solar cell was produced in the same manner as in Example 2, except that the poly (3-hexylthiophene) was changed to poly[2-methoxy-5-(3',7'-ethylhexyl)-1,4-phenylenevinylene] (MEH-PPV).

### (Comparative Example 10)

An organic thin-film solar cell was produced in the same manner as in Example 2, except that the poly (3-hexylthiophene) was changed to poly[(9,9-di-n-octylfluorenyl-2,7-diyl)-alt-(benzo[2,1,3] thiadiazol-4,8-diyl)] (F8BT).

Examples 13 to 14 and Comparative Examples 11 to 13 each describe production of an organic thin-film solar cell in which a photoelectric conversion layer is a composite film.

### (Example 13)

An organic thin-film solar cell was produced in the same manner as in Example 2, except that a mixture of antimony sulfide (acting mainly as an N-type semiconductor) and copper phthalocyanine (acting mainly as a P-type semiconductor) was formed into a composite film having a thickness of 100 nm by co-deposition, and the composite film was annealed at a temperature of 260°C for 2 minutes. The volume ratio between the antimony sulfide and the copper phthalocyanine was 8:2.

### (Example 14)

An organic thin-film solar cell was produced in the same manner as in Example 2, except that a mixture of antimony sulfide and copper phthalocyanine was formed into a composite film having a thickness of 160 nm, and the composite film was annealed at a temperature of 260°C for 2 minutes by co-deposition. The volume ratio between the antimony sulfide and the copper phthalocyanine was 6:4.

### (Comparative Example 11)

### <Anode>

An ITO film having a thickness of 240 nm was formed as an anode on a glass substrate. The ITO film was subjected to ultrasonic cleaning for 10 minutes each with acetone, methanol, and isopropyl alcohol in this order, followed by drying.

### <Hole transport layer>

A layer of poly(3,4-ethylene dioxythiophene):poly(styrene sulfonate) (PEDOT:PSS) having a thickness of 50 nm was formed as a hole transport layer on a surface of the ITO film by spin coating.

### <Photoelectric conversion layer (composite film)>

A fullerene derivative (8 parts by weight, PCBM, produced by American Dye Source, Inc.) and poly(3-hexylthiophene) (10 parts by weight) were dispersed and dissolved in chlorobenzene (600 parts by weight) to prepare a mixed solution. The mixed solution was applied to a surface of the hole transport layer to form a composite film having a thickness of 150 nm.

### <Electron transport layer>

An electron transport layer having a thickness of 50nm was formed using a zinc oxide nanoparticle dispersion on a surface of the photoelectric conversion layer by spin coating.

### <Cathode>

An aluminum film having a thickness of 100 nm as a cathode was formed on a surface of the electron transport layer by vacuum evaporation to give an organic thin-film solar cell.

### (Comparative Example 12)

An organic thin-film solar cell was produced in the same manner as in Comparative Example 11, except that the fullerene derivative was changed to zinc oxide nano particles.

### (Comparative Example 13)

An organic thin-film solar cell was produced in the same manner as in Comparative Example 11, except that the fullerene derivative was changed to zinc sulfide nano particles.

### (Evaluation)

### <Measurement of photoelectric conversion efficiency>

A power source (Model 236, produced by Keithley Instruments Inc.) was connected between electrodes of an organic thin-film solar cell. The photoelectric conversion efficiency of the organic thin-film solar cell was measured with a solar simulator (produced by Yamashita Denso Corporation) at an intensity of 100 mW/cm². The measured value was standardized based on the photoelectric conversion efficiency in Comparative Example 3 regarded as 1.00 (relative photoelectric conversion efficiency (ratio relative to Comparative Example 3)).

### <Measurement of photoelectric conversion efficiency after weathering test>

A weathering test was performed by glass sealing an organic thin-film solar cell, and exposing it to light at an intensity of 60 mW/cm² for 24 hours under a temperature of 60°C and a humidity of 35%. The photoelectric conversion efficiency was measured before and after the weathering test in the aforementioned manner. A relative conversion efficiency was determined which is a ratio of the photoelectric conversion efficiency after the weathering test relative to the initial photoelectric conversion efficiency (initial value) regarded as 1.00.

### <Comprehensive evaluation>

Each cell was comprehensively evaluated according to the following criteria.
Poor: The relative photoelectric conversion efficiency (ratio relative to Comparative Example 3) was not more than 1; or the relative conversion efficiency after the weathering test (ratio relative to the initial value) was not more than 0.8.
Good: The relative photoelectric conversion efficiency (ratio relative to Comparative Example 3) was more than 1 and not more than 5; and the relative conversion efficiency after the weathering test (ratio relative to the initial value) was more than 0.8.
Excellent: The relative photoelectric conversion efficiency (ratio relative to Comparative Example 3) was more than 5; and the relative conversion efficiency after the weathering test (ratio relative to the initial value) was more than 0.8.

**Table 1**

| | | Example 1 | Example 2 | Example 3 | Example 4 | Example 5 | Example 6 |
|---|---|---|---|---|---|---|---|
| Electron transport layer | | Zinc oxide | Zinc oxide | - | Zinc oxide | Zinc oxide | Zinc oxide |
| Hole transport layer | | - | PEDOT:PSS | PEDOT:PSS | PEDOT:PSS | PEDOT:PSS | PEDOT:PSS |
| Photoelectric conversion layer (Laminated body) | N-type semiconductor | Antimony sulfide | Antimony sulfide | Antimony sulfide | Bismuth sulfide | Antimony sulfide | Antimony sulfide |
| | P-type semiconductor | PEDOT:PSS | Poly(3-hexylthiophene) | Poly(3-hexylthiophene) | Poly(3-hexylthiophene) | Poly(3-hexylthiophene) | Poly(3-hexylthiophene) |
| Annealing temperature | | 260 | 260 | 260 | 260 | 240 | 200 |
| Evaluation | Relative photoelectric conversion efficiency (ratio relative to Comparative Example 3) | 4.2 | 5.8 | 3.8 | 3 | 3.2 | 2.4 |
| | Relative conversion efficiency after weathering test (24 hours) (ratio relative to initial value) | 0.9 | 1 | 1 | 1 | 1 | 1 |
| | Comprehensive evaluation | Good | Excellent | Good | Good | Good | Good |

**Table 2**

| | | Example 7 | Example 8 | Example 9 | Example 10 | Example 11 | Example 12 |
|---|---|---|---|---|---|---|---|
| Electron transport layer | | Zinc oxide | Zinc oxide | Zinc oxide | Zinc oxide | Zinc oxide | Zinc oxide |
| Hole transport layer | | PEDOT:PSS | PEDOT:PSS | PEDOT:PSS | PEDOT:PSS | PEDOT:PSS | PEDOT:PSS |
| Photoelectric conversion layer (Laminated body) | N-type semiconductor | Antimony sulfide | Antimony sulfide | Antimony sulfide | Antimony sulfide | Antimony sulfide | Antimony sulfide |
| | P-type semiconductor | PBDTTT-CF | Copper phthalocyanine | Zinc phthalocyanine | *α*-alkyl group-substituted phthalocyanine | Benzoporphyrin | Benzoporphyrin (converted from bicycloporphyrin) |
| Annealing temperature | | 260 | 260 | 260 | 260 | 260 | 260 |
| Evaluation | Relative photoelectric conversion efficiency (ratio relative to Comparative Example 3) | 6.4 | 4.6 | 5.9 | 4.8 | 5.6 | 5.8 |
| | Relative conversion efficiency after weathering test (24 hours) (ratio relative to initial value) | 0.9 | 1 | 1 | 1 | 1 | 1 |
| | Comprehensive evaluation | Excellent | Good | Excellent | Excellent | Excellent | Excellent |

**Table 3**

| | | Comparative Example 1 | Comparative Example 2 | Comparative Example 3 | Comparative Example 4 | Comparative Example 5 | Comparative Example 6 | Comparative Example 7 | Comparative Example 8 | Comparative Example 9 | Comparative Example 10 |
|---|---|---|---|---|---|---|---|---|---|---|---|
| Electron transport layer | | Zinc oxide | Zinc oxide | Zinc oxide | Zinc oxide | Zinc oxide | Zinc oxide | Zinc oxide | Zinc oxide | Zinc oxide | Zinc oxide |
| Hole transport layer | | PEDOT:PSS | PEDOT:PSS | PEDOT:PSS | PEDOT:PSS | PEDOT:PSS | PEDOT:PSS | - | PEDOT:PSS | PEDOT:PSS | PEDOT:PSS |
| Photoelectric conversion layer (Laminated body) | N-type semiconductor | Fullerene | Fullerene | Fullerene | Zinc oxide | Tin sulfide | Zinc sulfide | Antimony sulfide | Antimony sulfide | Antimony sulfide | Antimony sulfide |
| | P-type semiconductor | Poly(3-hexylthiophene) | Poly(3-hexylthiophene) | Poly(3-hexylthiophene) | Poly(3-hexylthiophene) | Poly(3-hexylthiophene) | Poly(3-hexylthiophene) | Copper sulfide | MDMO-PPV | MEH-PPV | F8BT |
| Annealing temperature | | 260 | 180 | - | 260 | 260 | 260 | 260 | 260 | 260 | 260 |
| Evaluation | Relative photoelectric conversion efficiency (ratio relative to Comparative Example 3) | 0.5 | 0.8 | 1 | 1 | 0.7 | 0.8 | 0.2 | 2 | 2.2 | 1.8 |
| | Relative conversion efficiency after weathering test (24 hours) (ratio relative to initial value) | 0.4 | 0.4 | 0.4 | 0.3 | 0.3 | 0.4 | 1 | 0.4 | 0.3 | 0.2 |
| | Comprehensive evaluation | Poor | Poor | Poor | Poor | Poor | Poor | Poor | Poor | Poor | Poor |

**Table 4**

| | | Example 13 | Example 14 | Comparative Example 11 | Comparative Example 12 | Comparative Example 13 |
|---|---|---|---|---|---|---|
| Electron transport layer | | Zinc oxide | Zinc oxide | Zinc oxide | Zinc oxide | Zinc oxide |
| Hole transport layer | | PEDOT:PSS | PEDOT:PSS | PEDOT:PSS | PEDOT:PSS | PEDOT:PSS |
| Photoelectric conversion layer (Composite film) | N-type semiconductor | Antimony sulfide | Antimony sulfide | Fullerene derivative | Zinc oxide | Zinc sulfide |
| | P-type semiconductor | Copper phthalocyanine | Copper phthalocyanine | Poly(3-hexylthiophene) | Poly(3-hexylthiophene) | Poly(3-hexylthiophene) |
| Evaluation | Relative photoelectric conversion efficiency (ratio relative to Comparative Example 3) | 5.8 | 7.2 | 5.4 | 3.8 | 1 |
| | Relative conversion efficiency after weathering test (24 hours) (ratio relative to initial value) | 1 | 1 | 0.3 | 0.3 | 0.4 |
| | Comprehensive evaluation | Excellent | Excellent | Poor | Poor | Poor |

### INDUSTRIAL APPLICABILITY

The present invention enables to provide an organic thin-film solar cell that has a high photoelectric conversion efficiency and excellent durability.

### REFERENCE SIGNS LIST

1 Organic thin-film solar cell
2 Substrate
3 Transparent electrode (anode)
4 Organic semiconductor layer
5 Layer containing a sulfide of a Group 15 element in the periodic table
6 Electron transport layer
7 Electrode (cathode)
8 Organic thin-film solar cell
9 Substrate
10 Transparent electrode (anode)
11 Hole transport layer
12 Organic semiconductor portion
13 Portion containing a sulfide of a Group 15 element in the periodic table
14 Composite film
15 Electron transport layer
16 Electrode (cathode)

## Claims

1. An organic thin-film solar cell comprising a photoelectric conversion layer,
wherein the photoelectric conversion layer includes a portion containing a sulfide of a Group 15 element in the periodic table and an organic semiconductor portion contacting with each other, and
the organic semiconductor portion comprises an organic semiconductor, the organic semiconductor comprising a polythiophene derivative, a phthalocyanine derivative, a naphthalocyanine derivative, or a benzoporphyrin derivative.

2. The organic thin-film solar cell according to claim 1,
wherein the sulfide of a Group 15 element in the periodic table is antimony sulfide.

3. The organic thin-film solar cell according to claim 1 or 2,
wherein the photoelectric conversion layer is a laminated body including a layer containing a sulfide of a Group 15 element in the periodic table and an organic semiconductor layer.

4. The organic thin-film solar cell according to claim 3,
wherein the photoelectric conversion layer including a layer containing a sulfide of a Group 15 element in the periodic table and an organic semiconductor layer is disposed between a pair of electrodes, and
the organic thin-film solar cell further comprises an electron transport layer between one of the electrodes and the layer containing a sulfide of a Group 15 element in the periodic table, and a hole transport layer between the other electrode and the organic semiconductor layer.

5. The organic thin-film solar cell according to claim 1 or 2,
wherein the photoelectric conversion layer is a composite film formed as a complex containing a mixture of the portion containing a sulfide of a Group 15 element in the periodic table and the organic semiconductor portion.

6. The organic thin-film solar cell according to claim 5,
wherein the photoelectric conversion layer that is a composite film formed as a complex containing a mixture of the portion containing a sulfide of a Group 15 element in the periodic table and the organic semiconductor portion is disposed between a pair of electrodes, and
the organic thin-film solar cell further comprises an electron transport layer between one of the electrodes and the photoelectric conversion layer, and a hole transport layer between the other electrode and the photoelectric conversion layer.
